# EUROPÄISCHE PATENTSCHRIFT

(11) **EP 0 643 396 B1**
(45) Veröffentlichungstag und Bekanntmachung des Hinweises auf die Patenterteilung: **30.12.1998**
(21) Anmeldenummer: 94114169.9
(22) Anmeldetag: 09.09.1994
(51) Int. Cl.: H01B 1/02, H01B 1/04, H01B 1/06, H01B 1/08, H01B 3/10, H01B 3/12, H01B 1/14, H01B 1/16, H01B 1/18, H01B 1/20, H01B 1/22, H01B 1/24, C09D 5/24, C09D 7/00, C09D 175/04, H01L 21/48

(54) **Pasten zur Beschichtung von Substraten, Verfahren zu ihrer Herstellung sowie deren Verwendung**
Pastes for coating substrates, process for their manufacture and application
Pastes d'induction de substrats, procédés pour leur fabrication et application

(30) Priorität: 13.09.1993 DE 4331006; 06.09.1994 DE 4431723
(43) Veröffentlichungstag der Anmeldung: 15.03.1995
(73) Patentinhaber: H.C. Starck GmbH & Co. KG, 38642 Goslar (DE)
(72) Erfinder: Krismer, Bruno, Dr., D-38640 Goslar (DE); Thies, Uwe, D-38640 Goslar (DE); Ladstätter, Peter, D-38640 Goslar (DE); Hünert, Rudolf, Dr., D-38644 Goslar (DE)
(74) Vertreter: Steiling, Lothar, Dr.

(56) Entgegenhaltungen:
- DE-A- 3 408 238
- US-A- 4 111 851
- US-A- 5 041 242
- US-A- 5 156 770

## Beschreibung

Die vorliegende Erfindung betrifft Pasten zur Herstellung von Leiterbahnen, Widerständen, Kondensatoren und Loten aus in flüssiger Dispersion vorliegenden pulverförmigen Materialien aus der Gruppe der Metalle, Metallverbindungen und/oder -Legierungen und/oder Bor und/oder Kohlenstoff, Verfahren zu ihrer Herstellung sowie deren Verwendung.

Pasten zur Herstellung von Leiterbahnen, Widerständen, Kondensatoren oder Loten auf Basis organischer Lösemittel sind hinreichend bekannt. Gleichfalls bekannt sind derartige Pasten zur Herstellung von optischen Schichten sowie zur Abschirmung magnetischer, elektromagnetischer oder Neutronenstrahlung.

Die Beschichtung von Substraten mit derartigen Pasten, bei denen es sich um Dispersionen von pulverförmigen Materialien in organischen Binde- und/oder Lösungsmitteln handelt, ist ebenfalls seit vielen Jahren Stand der Technik. So gehen aus den Patenten US A 4.024.629 und US A 4.546.065 Pasten hervor, in denen als typische Dispersions- und Lösungsmittel Mischungen von Cyclohexanol, Ethanol und Toluol angegeben sind. Diese Gemische bekannter polarer, unpolarer und aromatischer Lösemittel sind in verschiedener Hinsicht ökologisch bedenklich. Sie sind geruchsintensiv, feuergefährlich, abwassergefährdend und teilweise toxisch. Entsprechend aufwendig müssen beim Einsatz dieser Pasten die Arbeitsschutzvorkehrungen sowie die Einrichtungen zur Emissionsvermeidung ausgelegt werden.

Generell ist festzustellen, daß alle derzeit bekannten Pasten auf Basis üblicher organischer Lösungsmittel, gegebenenfalls in Kombination mit Bindemitteln hergestellt sind. Sind Bindemittel enthalten, so kommt diesen die Funktion der Filmbildung zu.

Wasserlacke enthalten Pigmente in Kombination mit einem oder mehreren wasserverdünnbaren Bindemitteln. So beschreibt die DE-A 4133487 die Verwendung von Metallpigmenten in Kombination mit wasserverdünnbaren Bindemitteln auf Basis von Polyestern, Polyacrylaten oder Polyurethanen. Die Funktion der Bindemittel ist dabei die Bildung eines zusammenhängenden Filmes, der das aufzubringende Pigment einschließt und damit fixiert und schützt.

Ähnlich offenbart die US-A 5171631 die Einbindung des als Farbstoff verwendeten Pigments Titandioxid in ein System aus organischen Bindemitteln - hier auf Basis von Vinylacetat/Butylacrylat Copolymeren unter Verwendung von Aluminiumoxidtrihydrat als nicht-ionogenem rhelogischen Additiv, eingebracht in das Lösemittel Propylenglykol. Auch in diesem Fall ist die Funktion der aufgebrachten Schicht nur in Gegenwart des/der Bindelmittel gegeben.

Die DE-A 4202705 offenbart die Beschichtung von Substraten mit Edelmetallen aus einem System auf Wasserbasis, in dem die Metallkomponente als Lösung vorliegt. Auch in diesem Fall wird ein polymerer organischer Film- bzw. Matrixbildner benötigt. Das abzuscheidende Edelmetall wird dabei aus einer Lösung durch in situ Reduktion direkt auf der Oberfläche abgelagert, wobei die bevorzugte Edelmetallkonzentration in Lösung bei 0.01 bis 2 Gew. %, vorzugsweise 0.02 bis 0.5 Gew.% liegt. Es wird also die Abscheidung eines Metalls unter Zuhilfenahme eines Bindemittels aus der Lösung offenbart, nicht jedoch die Ablagerung aus einer Dispersion.

Es war daher die Aufgabe der Erfindung, Pasten bereitzustellen, die hinsichtlich ihrer technischen Eignung den bekannten Pasten nicht nachstehen, andererseits aber die geschilderten Nachteile der Pasten des Standes der Technik nicht aufweisen.

Es wurden nun Pasten gefunden, die diese Aufgabe erfüllen. Es handelt sich dabei um Pasten zur Herstellung von Leiterbahnen, Widerständen, Kondensatoren oder Loten aus in flüssiger Dispersion vorliegenden pulverförmigen Materialien aus der Gruppe der Metalle, Metallverbindungen und/oder -Legierungen und/oder Bor und/oder Kohlenstoff, dadurch gekennzeicnet, daß die pulverförmigen Materialien aus eines oder mehreren der Gruppe als Refraktärmetalle, Edelmetalle, Übergangsmetalle, Refraktärmetalloxide, -Oxidverbindungen, Silizide und Titanate Zirkonoxid, Indium-Zinnoxid und Seltenerdeoxide sind und sich bei den flüssigen Dispersionen um solche auf wäßriger Basis handelt, die wasserverdünnbare nichtionische rheologische Additive in Mischungen von 0,2 bis 20 Gew.-%, bezogen auf den Feststoffgehalt, enthalten und frei sind von filmbildenden Substanzen und organischen Lösungsmitteln.

Die erfindungsgemäßen Pasten sind frei von organischen Lösemitteln. Sie können ohne den Einsatz organischer Lösemitteln und/oder FCKW und/oder CKW zu funktionsfähigen Schichten verarbeitet werden.

Die erfindungsgemäßen Pasten sind mit Wasser verdünnbar. Alle additiven Inhaltstoffe, die für die Einstellung der rheologischen Eigenschaften, wie z.B. der Viskosität der erfindungsgemäßen Pasten benötigt werden, können bei der Herstellung von Beschichtungen während einer Temperaturbehandlung entweder vollständig entfernt werden oder als inerte Rückstände in den temperaturbehandelten Schichten verbleiben. Im Bedarfsfalle sind sie während der Verarbeitung, z.B. bei der Reinigung der Verarbeitungsanlagen, durch Wasser leicht zu entfernen und erfordern somit nicht die Anwendung von organischen Lösemitteln. Darüber hinaus sind die erfindungsgemäßen Pasten geruchsneutral und nicht feuergefährlich. Ökologische Beeinträchtigungen, wie sie bei den derzeit eingesetzten Pasten bemängelt werden, sind bei den erfindungsgemäßen Pasten nicht zu erwarten.

Bevorzugt sind die erfindungsgemäßen Pasten Mischungen aus den pulverförmigen Materialien und wasserverdünnbaren, rheologisch wirksamen Additiven. Hierbei kann es sich vorteilhaft um wäßrige Kieselsäure Dispersionen handeln, bevorzugt sind auch als nichtionogene rheologische Additive Assoziativ-Verdicker auf Polyglykolether, Polyurethan-Basis, besonders bevorzugt solche auf Basis von Toluylendiisocyanaten (TDI) und/oder Hexamethylendiisocyanaten (HDI). Gleichfalls bevorzugt sind Diphenylmethandiisocyanate (MDI) und/oder Isophorondiisicyanate (IPDI). Im Bedarfsfall können weitere Netzmittel und/oder Stabilisatoren enthalten sein.

Typische dispergierte pulverförmige Materialien sind Metalle - wie z. B. Pulver der Refraktärmetalle Niob, Tantal, Molybdän, Wolfram oder der Übergangsmetalle wie z.B. Eisen, Cobalt, Nickel, Chrom, Kupfer oder der Edelmetalle Silber, Gold, Platin, Palladium, Legierungen - z.B. Edelmetalllegierungen wie Silber/Palladium-, Oxide - wie z.B. die Oxide der Refraktärmetalle Niob, Tantal, Molybdän, Wolfram oder Oxide mit besonderen elektrischen Eigenschaften wie z.B. Zirkonoxid, Indium-Zinnoxid, Tantalate, Niobate, Titanate Seltenerdoxide oder Oxide mit magnetischen Eigenschaften, Nitride - wie z. B. Titannitrid oder Aluminiumnitrid oder Bornitrid, Carbide und Carbonitride - wie z.B. Wolframcarbid, Tantalcarbid oder Wolframtitancarbid, Titancarbinitrid, Bor oder Boride wie z.B. amorphes oder kristallines elementares Bor, Aluminiumborid, Seltenerdboride wie z.B. Europiumborid und/oder Gadoliniumborid, Silizide - wie z. B. Molybdänsilizide oder Wolframsilizide in stöchiometrischer und nichtstöchiometrischer Form, Chalkogenide wie z.B. Zinksulfid, Molybdänsulfid und/oder Wolframsulfid und/oder Kohlenstoff in verschiedenen Modifikationen. Die vorgenannten Feststoffe können einzeln oder als beliebige Mischungen vorliegen. Der Feststoffgehalt der erfindungsgemäßen Pasten beträgt bevorzugt 5 bis 95 Gew.%, besonders bevorzugt 50 bis 90 Gew.%.

Die Auswahl der in der Dispersion vorliegenden Inhaltstoffe sollte bevorzugt so gewählt sein, daß die Trockenmassen der Pasten nach einer Temperaturbehandlung auf 550 °C keine organischen Rest-Substanzen mehr enthalten.

Die erfindungsgemäßen Pasten können dadurch hergestellt werden, daß die pulverförmigen Materialien in Wasser dispergiert werden und die rheologischen Eigenschaften der wäßrigen Dispersionen mit Hilfe der rheologisch wirksamen Additive eingestellt werden. Dabei kann es vorteilhaft sein, die rheologischen Eigenschaften der Pasten zusätzlich durch Netzmittel zu beeinflussen. Übliche Polyurethanverdicker enthalten teilweise bereits geeignete Netzmittel.

Gegenstand dieser Erfindung ist auch die Verwendung der erfindungsgemäßen Pasten. Sie sind hervorragend geeignet für die Beschichtung von anorganischen Substraten, wie z.B. Glas, Keramik, Glaskeramik, Emaille und Metallen sowie auch solchen auf organischer Basis, wie z.B. von Kunststoffen. Bevorzugt geschieht dabei die Beschichtung der Substrate durch Drucktechniken, besonders bevorzugt Siebdruck, Offertdruck und/oder Rakeln und/oder Gießen und/oder Tauchen und/oder Sprühen und/oder elektrostatische Auftragsverfahren. Die notwendige Strukturierung der Schichten kann vorzugsweise drucktechnisch oder lithographisch - auch mittels UV-Lithographie - vorgenommen werden. Die Anwendung aller denkbaren Drucktechniken ist möglich. Besonders eignen sich die erfindungsgemäßen Pasten als Metallisierungspasten.

Im folgenden wird die Erfindung beispielhaft erläutert.

### Beispiele

### Beispiel 1 (Molybdän-Paste)

Zur Herstellung einer Molybdän-Paste wurden 70 Gew.% Molybdän-Metallpulver mit einer Durchschnittskorngröße von ca. 2 µm (FSSS) mit 5 Gew.% des Assoziativ-Verdickers Borchigel*) LW44 (HDI = Hexamethylendiisocyanat, Emulsion zu 44 % in Wasser), 8 Gew.% Borchigen*) DFN (Polyglykolether) und 3 Gew.% des Netzmittels Borchigen*) ND (Phosphorsäureesteraminsalz) mit Wasser (zu 100 Gew.%) mittels eines Walzenstuhls dispergiert. Die so hergestellte Paste eignet sich hervorragend zur Herstellung von Leiterbahnen in keramischen Multichipmodulen auf Basis Aluminiumoxid und erlaubt dabei insbesondere, auch die Durchkontaktierungen zwischen den einzelnen Lagen in einem drucktechnischen Schritt zu füllen.

### Beispiel 2 (Wolfram-Paste)

Eine Dispersion von 75 Gew.% Wolfram-Metallpulver mit FSSS = 1,4 µm und 12,5 Gew.% des Assoziativ-Verdickers Borchigel*) DP40 (TDI = Toluylendiisocyanat, Emulsion zu 44 % in Wasser) wurde mit Wasser (zu 100 Gew.%) als Metallisierungspaste zubereitet.

### Beispiel 3 (Silizid-Paste)

Entsprechend Beispiel 1 wurde eine Dispersion von 60 Gew.% Molybdändisilizid mit einer durchschnittlichen Korngröße von 10 µm (FSSS) und 11 Gew.% des PU-Additivs Borchigen*) DFN in Wasser (Rest zu 100 %) hergestellt. Das rheologische Verhalten der Paste wurde noch durch die Zugabe von 5 Gew.-% Kieselsäuredispersion (30 %ige Dispersion in Wasser) eingestellt. Die auf diese Weise hergestellte Paste eignet sich hervorragend zur Aufbringung von Heizleiterschichten auf keramischen Substraten, wie z.B. Siliziumnitrid.

### Beispiel 4 (Oxid-Paste)

Entsprechend den vorangegangenen Beispielen wurde eine Dispersion von 65 Gew.% Nioboxid mit einer durchschnittlichen Korngröße von 2 µm (FSSS) und 5 Gew.% Borchigel*) LW44 (HDI) sowie 11 Gew.% Borchigen*) ND in Wasser als Paste für die Herstellung einer dielektrischen Beschichtung zubereitet.

### Beispiel 5 (Legierungs-Paste)

75 Gew.% einer pulverisierten Nickel/Chrom/Bor-Legierung mit einer durchschnittlichen Korngröße von 15 µm und 8 Gew.% Borchigen*) DFN sowie 3 Gew.% Borchigen*) ND wurden mittels eines Walzenstuhls in Wasser dispergiert. Es ergab sich eine brauchbare Metallisierungspaste.

### Beispiel 6 (Metallpaste)

81,6 Gew. % Silberpulver mit einer mittleren Korngröße von 0.3-5 mm nach FSSS und 7,4 Gew. % Borchigen*) DFN wurden mittels eines Dissolvers unter Argon-Atmosphäre in Wasser dispergiert. Es ergab sich eine Paste, die hervorragend geeignet ist zur Aufbringung von leitfähigen Schichten, wie z.B. der Kantenmetallisierung keramischer Kondensatoren oder zur Aufbringung von Widerstandsbahnen auf Glas.

### Beispiel 7 (Metallpaste)

72,3 Gew. % Nickelpulver mit einer mittleren Konrgröße von < 3 mm nach FSSS und sphärischer Kornform wurden mit 8,9 Gew. % Borchigen*) DFN in Wasser mittels eines Dissolvers unter Argon-Atmosphäre dispergiert. Die auf diese Weise hergestellte Nickelpaste ist hervorragend geeignet zur Herstellung leitfähiger Schichten, wie z. B. der innenliegenden Leiterzüge keamischer Kondensatoren.

### Beispiel 8 (Metallpaste)

90,6 Gew. % Tantalpulver in Kondensatorqualität wurden mit je 0,3 Gew. % Borchigen *) DFN und Borchigen *) ND in Wasser mittels einer Knetervorrichtung dispergiert. Die auf diese Weise hergestellte Paste eignet sich hervorragend zur Herstellung von Anoden für Elektrolytkondensatoren.
^{*}) Borchigel und Borchigen sind registrierte Warenzeichen der Firma Gebr. Borchers AG, Goslar.

Die in den Beispielen angeführten Pasten wurden mittels Siebdruck auf geeignete Substrate aufgebracht und bei Temperaturen bis zu 550 °C getrocknet. Die Trocknung erfolgte für oxidhaltige Pasten an der Luft. Metallhaltige Pasten wurden unter Schutzgas bzw. im Vakuum getrocknet. Dabei wurden in allen Fällen die enthaltenen organischen Additive vollständig entfernt. Zusätzliche Reinigungsschritte waren nicht erforderlich. Anschließend wurde die Temperatur erhöht, so daß der Feststoff versinterte, bis er die geforderten Eigenschaften erreicht hatte.

### Beispiel 9

48 Gew.-% eines Indium-Zinnoxid-Pulvers mit einer mittleren Korngröße von < 800 nm und 8 Gew.-% Borchigen*) DFN wurden mittels eines Dissolvers in Wasser dispergiert. Es ergab sich eine Paste, die sich ausgezeichnet eignet zur Aufbringung leitfähigen, transparenten Strukturen auf Glas.

### Beispiel 10

32 Gew.-% eines Nioboxids mit einer mittleren Korngröße von 0,3 bis 0,6 µm und 3 Gew.-% Borchigel*) LW 44 (HDI) sowie 8 Gew.-% Borchigen*) ND wurden unter Nutzung einer Perlmühle in Wasser dispergiert. Die so hergestellte Paste eignet sich zur Herstellung von Beschichtungen zur Steigerung des Brechungsindex auf Glas.

### Beispiel 11

50 Gew.-% eines Siliciumdioxids mit einer mittleren Korngröße von 50...100 nm und 4 Gew.-% Borchigel*) LW 44 (HDI) sowie 8,5 Gew.-% Borchigen*) ND wurden in Wasser dispergiert. Die so hergestellte Paste eignet sich zur Herstellung von Beschichtungen zur Verminderung der Reflexion auf Glas.

## Patentansprüche

1. Pasten zur Herstellung von Leiterbahnen, Widerständen, Kondensatoren oder Loten aus in flüssiger Dispersion vorliegenden pulverförmigen Materialien aus der Gruppe der Metalle, Metallverbindungen und/oder -legierungen und/oder Bor und/oder Kohlenstoff, dadurch gekennzeichnet, daß die pulverförmgen Materialien eines oder mehrere der Gruppe der Refraktärmetalle, Edelmetalle, Übergangsmetalle, Oxidverbindungen der Refraktärmetalle, Silizide, Titanate, Zirkonoxid, Indium-Zinnoxid und Seltenerdeoxide sind und es sich bei den flüssigen Dispersionen um solche auf wäßriger Basis handelt, die wasserverdünnbare, nichtionogene, rheologische Additive in Mischungen von 0,2 bis 20 Gew.-%, bezogen auf den Feststoffgehalt, enthalten und frei sind von filmbildenden Substanzen und organischen Lösungsmitteln.

2. Pasten gemäß Anspruch 1, dadurch gekennzeichnet, daß die Menge der Additive 0,5 bis 15 Gew.-% beträgt.

3. Pasten gemäß einem der Ansprüche 1 oder 2, dadurch gekennzeichnet, daß die nichtionogenen, rheologischen Additive Assoziativ-Verdicker auf Polyglykolether-Basis sind.

4. Pasten gemäß einem der Ansprüche 1 oder 2, dadurch gekennzeichnet, daß die nichtionogenen, rheologischen Additive Assoziativ-Verdicker auf Polyurethan-Basis sind.

5. Pasten gemäß Anspruch 4, dadurch gekennzeichnet, daß es sich bei den Assoziativ-Verdickern um solche auf Basis von Toluylen-diisocyanaten (TDI) und/oder Hexamethylen-diisocyanaten (HDI) handelt.

6. Pasten gemäß einem oder mehreren der Ansprüche 1 bis 5, dadurch gekennzeichnet, daß sie einen Gehalt von 5 bis 95 Gew.-% der pulverförmigen Materialien aufweisen.

7. Pasten gemäß einem oder mehreren der Ansprüche 1 bis 6, dadurch gekennzeichnet, daß sie einen Feststoffgehalt von 50 bis 90 Gew.-% der pulverförmigen Materialien aufweisen.

8. Pasten gemäß einem oder mehreren der Ansprüche 1 bis 7, dadurch gekennzeichnet, daß ihre Trockenmassen nach einer Temperaturbehandlung bei 550°C keine organischen Restsubstanzen mehr enthalten.

9. Pasten gemäß einem oder mehreren der Ansprüche 1 bis 8, dadurch gekennzeichnet, daß die Pasten Metallisierungspasten sind, wobei die pulverförmigen Materialien Refraktärmetalle aus der Gruppe Niob, Tantal, Molybdän, Wolfram, Rhenium, Edelmetalle aus der Gruppe Gold, Silber, Platin, Palladium und/oder Übergangsmetalle aus der Gruppe Eisen, Chrom, Cobalt, Nickel und Titan sind.

10. Pasten gemäß einem oder mehreren der Ansprüche 1 bis 8, dadurch gekennzeichnet, daß die pulverförmigen Materialien der Gruppe der Refraktärmetalloxide, der Niobate und/oder Tantalate und/oder Titanate angehören.

11. Pasten gemäß einem oder mehreren der Ansprüche 1 bis 8, dadurch gekennzeichnet, daß die Silizide bevorzugt Molybdänsilizid und/oder Wolframsilizid unterschiedlicher Stöchiometrie sind.

12. Verfahren zur Herstellung der Pasten gemäß einem oder mehreren der Ansprüche 1 bis 11, dadurch gekennzeichnet, daß die pulverförmigen Materialien in Wasser dispergiert und mit den Assoziativ-Verdickern versetzt werden.

13. Verwendung der Pasten gemäß einem oder mehreren der Ansprüche 1 bis 11 für die Beschichtung von Substraten durch Drucktechniken, vorzugsweise Siebdruck, Offsetdruck und/oder Rakeln und/oder Gießen und/oder Tauchen und/oder Sprühen und/oder elektrostatische Aufragsverfahren.

14. Verwendung der Pasten gemäß einem oder mehreren der Ansprüche 1 bis 11 für Schichten, die mittels Drucktechnik oder lithographisch strukturiert werden.

## Claims

1. Pastes for manufacturing printed conductors, resistors, capacitors or solders from powdery materials present in liquid dispersion from the group of the metals, metal compounds and/or alloys and/or boron and/or carbon, characterised in that the powdery materials are one or more of the group of the refractory metals, precious metals, transition metals, oxide compounds of refractory metals, silicides, titanates, zirconium oxide, indium-tin oxide and rare earth oxides and the liquid dispersions are ones based on water which contain water-dilutable, nonionic, rheological additives in mixtures of 0.2 to 20 wt %, referred to the solid content, and are free of film-forming substances and organic solvents.

2. Pastes according to claim 1, characterised in that the amount of the additives comes to 0.5 to 15 wt %.

3. Pastes according to one of claims 1 or 2, characterised in that the nonionic, rheological additives are associative thickeners based on polyglycol ether.

4. Pastes according to one of claims 1 or 2, characterised in that the nonionic, rheological additives are associative thickeners based on polyurethane.

5. Pastes according to claim 4, characterised in that the associative thickeners are ones based on toluylene diisocyanates (TDI) and/or hexamethylene diisocyanates (HDI).

6. Pastes according to one or more of claims 1 to 5, characterised in that they have a content of 5 to 95 wt % of the powdery materials.

7. Pastes according to one or more of claims 1 to 6, characterised in that they have a solid content of 50 to 90 wt % of the powdery materials.

8. Pastes according to one or more of claims 1 to 7, characterised in that their solids do not contain any residual organic substances after a heat treatment at 550 °C.

9. Pastes according to one or more of claims 1 to 8, characterised in that the pastes are metallization pastes, wherein the powdery materials are refractory metals from the group niobium, tantalum, molybdenum, tungsten, rhenium, precious metals from the group gold, silver, platinum, palladium and/or transition metals from the group iron, chromium, cobalt, nickel and titanium.

10. Pastes according to one or more of claims 1 to 8, characterised in that the powdery materials belong to the group of the refractory metal oxides, the niobates and/or tantalates and/or titanates.

11. Pastes according to one or more of claims 1 to 8, characterised in that the silicides are preferably molybdenum silicide and/or tungsten silicide of varying stoichiometry.

12. Process for manufacturing the pastes according to one or more of claims 1 to 11, characterised in that the powdery materials are dispersed in water and are mixed with the associative thickeners.

13. Use of the pastes according to one or more of claims 1 to 11 for the coating of substrates by printing techniques, preferably screen printing, offset printing and/or knife application and/or pouring and/or dipping and/or spraying and/or electrostatic deposition methods.

14. Use of the pastes according to one or more of claims 1 to 11 for layers which are structured by means of a printing technique or litho-graphically.

## Revendications

1. Pâtes pour la fabrication de pistes conductrices, de résistances, de condensateurs ou de métaux d'apport de brasage constituées par des matières pulvérulentes présentes sous forme d'une dispersion liquide, choisies parmi le groupe comprenant des métaux, des composés et/ou des alliages métalliques et/ou du bore et/ou du carbone, caractérisées en ce que les matières pulvérulentes représentent un ou plusieurs membres du groupe comprenant les métaux réfractaires, les métaux précieux, les métaux transitoires, des composés d'oxydes des métaux réfractaires, des siliciures, des titanates, de l'oxyde de zirconium, de l'oxyde d'indium-étain et des oxydes des terres rares, et il s'agit, en ce qui concerne les dispersions liquides, de dispersions à base aqueuse qui contiennent des additifs rhéologiques non ionogènes diluables dans l'eau dans des mélanges de 0,2 à 20% en poids rapportés à la teneur en substances solides et qui sont exemptes de substances filmogènes et de solvants organiques.

2. Pâtes selon la revendication 1, caractérisées en ce que la quantité des additifs s'élève de 0,5 à 15% en poids.

3. Pâtes selon la revendication 1 ou 2, caractérisées en ce que les additifs rhéologiques non ionogènes sont des épaississants associatifs à base d'éther de polyglycol.

4. Pâtes selon la revendication 1 ou 2, caractérisées en ce que les additifs rhéologiques non ionogènes sont des épaississants associatifs à base de polyuréthanne.

5. Pâtes selon la revendication 4, caractérisées en ce que, en ce qui concerne les épaississants associatifs, il s'agit d'épaississants à base de toluylènediisocyanates (TDI) et/ou d'hexaméthylène-diisocyanates (HDI).

6. Pâtes selon une ou plusieurs des revendications 1 à 5, caractérisées en ce qu'elles présentent une teneur de 5 à 95% en poids en matières pulvérulentes.

7. Pâtes selon une ou plusieurs des revendications 1 à 6, caractérisées en ce qu'elles présentent une teneur en substances solides représentant de 50 à 90% en poids des matières pulvérulentes.

8. Pâtes selon une ou plusieurs des revendications 1 à 7, caractérisées en ce que leurs matières sèches après un traitement thermique à 550°C ne contiennent plus de substances résiduelles organiques.

9. Pâtes selon une ou plusieurs des revendications 1 à 8, caractérisées en ce que les pâtes sont des pâtes de métallisation, les matières pulvérulentes représentant des métaux réfractaires choisis parmi le groupe comprenant le niobium, le tantale, le molybdène, le tungstène, le rhénium, des métaux précieux choisis parmi le groupe comprenant l'or, l'argent, le platine, le palladium, et/ou des métaux transitoires choisis parmi le groupe comprenant le fer, le chrome, le cobalt, le nickel et le titane.

10. Pâtes selon une ou plusieurs des revendications 1 à 8, caractérisées en ce que les matières pulvérulentes appartiennent au groupe des oxydes de métaux réfractaires, des niobiates et/ou des tantalates et/ou des titanates.

11. Pâtes selon une ou plusieurs des revendications 1 à 8, caractérisées en ce que les siliciures, de préférence le siliciure de molybdène et le siliciure de tungstène, possèdent des stoechiométries différentes.

12. Procédé pour la préparation des pâtes selon une ou plusieurs des revendications 1 à 11, caractérisé en ce qu'on met les matières pulvérulentes en dispersion dans de l'eau et on leur ajoute les épaississants associatifs.

13. Utilisation des pâtes selon une ou plusieurs des revendications 1 à 11, pour l'enduction de substrats par des techniques d'impression, de préférence la sérigraphie, l'impression offset et/ou par raclage et/ou par coulée et/ou par immersion et/ou par pulvérisation et/ou par des procédés d'application électrostatiques.

14. Utilisation des pâtes selon une ou plusieurs des revendications 1 à 11, pour des couches que l'on structure via une technique d'impression ou par voie lithographique.
